# EUROPÄISCHE PATENTSCHRIFT

(11) **EP 1 269 629 B1**
(45) Veröffentlichungstag und Bekanntmachung des Hinweises auf die Patenterteilung: **08.10.2003**
(21) Anmeldenummer: 01942808.5
(22) Anmeldetag: 16.01.2001
(51) Int. Cl.: H03K 17/78, H03K 17/94, H03K 17/96

(54) **OPTO-ELEKTRONISCHER SCHALTER MIT AUSWERTUNG VON BEWEGUNGSÄNDERUNGEN**
OPTO-ELECTRONIC SWITCH WHICH EVALUATES CHANGES IN MOTION
COMMUTATEUR OPTOELECTRONIQUE A EVALUATION DES VARIATIONS DE MOUVEMENT

(30) Priorität: 18.01.2000 DE 10001955
(43) Veröffentlichungstag der Anmeldung: 02.01.2003
(73) Patentinhaber: Reime, Gerd, 75328 Schömberg (DE)
(72) Erfinder: Reime, Gerd, 75328 Schömberg (DE)
(74) Vertreter: Reinhardt, Harry
(86) Internationale Anmeldenummer: EP0100431
(87) Internationale Veröffentlichungsnummer: WO01054276

(56) Entgegenhaltungen:
- EP-A- 0 551 240
- WO-A-86/01953
- WO-A-95/01561
- FR-A- 2 693 859
- US-A- 5 103 085
- PATENT ABSTRACTS OF JAPAN vol. 1997, no. 02, 28. Februar 1997 (1997-02-28) & JP 08 273503 A (NISSAN SHATAI CO LTD), 18. Oktober 1996 (1996-10-18)
- PATENT ABSTRACTS OF JAPAN vol. 007, no. 266 (P-239), 26. November 1983 (1983-11-26) & JP 58 147670 A (TOKYO SHIBAURA DENKI KK), 2. September 1983 (1983-09-02)
- PATENT ABSTRACTS OF JAPAN vol. 1996, no. 08, 30. August 1996 (1996-08-30) & JP 08 096677 A (YAMATAKE HONEYWELL CO LTD), 12. April 1996 (1996-04-12)
- PATENT ABSTRACTS OF JAPAN vol. 1996, no. 03, 29. März 1996 (1996-03-29) & JP 07 296670 A (NILES PARTS CO LTD), 10. November 1995 (1995-11-10)

## Beschreibung

Die Erfindung betrifft einen opto-elektronischen Schalter nach dem Oberbegriff des Anspruchs 1.

In fast allen elektrischen oder elektronischen Geräten werden Schalter zur manuellen Bedienung verwendet. Diese Schalter sind fast immer mechanisch aufgebaut, wobei zwei Metallteile in Kontakt bzw. außer Kontakt gebracht werden, um einen Stromkreis zu schließen bzw. zu öffnen. Dieser mechanische Aufbau hat jedoch unter anderem den Nachteil, dass er mechanische Verschleißteile und somit nur eine begrenzte Lebensdauer aufweist und grundsätzlich wasserempfindlich ist, so dass im Bedarfsfall eine aufwendige Kapselung notwendig ist.

Es sind schon optische Schalter bekannt geworden, die jedoch bisher recht aufwendig und somit teuer sind und noch nicht den geforderten Standard bezüglich der Funktionssicherheit aufweisen. Optische Schalter haben jedoch grundsätzlich Vorteile, da sie im allgemeinen ohne bewegliche mechanische Teile auskommen und der Schaltvorgang durch bloßes Antippen oder Berühren einer Schaltfläche oder durch bloße Näherung an einen Sensor ausgelöst werden kann.

Aus der DE 42 07 772 ist ein opto-elektronischer Sensorschatter bekannt, der mit einer Logikschaltung ein Antippen als Bewegungsmuster erkennt und diese als Schaltimpuls wertet, sofem das Antippen z.B. durch einen Finger eine gewisse Verweilzeit andauert. Dadurch soll insbesondere ein Antippen von einem Überwischen z.B. an einem Koch-Ceranfeld unterschieden werden. Da der Sensorschalter jedoch keine dynamische Bewegungsänderung erkennt, sind zusätzliche Sensoren als Blockiersensoren erforderlich, die das Antippen eines Fingers von größeren Gegenständen unterscheidbar machen und damit die Kosten und die Baugröße des Systems negative beeinflussen.

Aus der US 5,103,085 A ist ein optoelektronischer Sensorschalter bekannt, der z.B. die Annäherung eines Objekts an eine Schaufensterscheibe auch bei sonnenlicht erkennen soll. Findet für eine durch einen Timer vorgegebene Zeit eine statische Abdeckung des Sensors statt, wird eine Schaltung zur weiteren Betätigung wirksam geschalten. Damit ist die Erkennung eines Antippens mit den Schritten Annähem - Verweilen für eine kurze Zeit - Abheben nicht möglich. Aus diesem Grund können auch andere Bewegungen zu einem Auslösen der Schaltung führen.

Auch die WO-A 86/01953 arbeitet zur Erfassung einer Fingerbewegung mit statischen Signalen. In einer Sample and Hold Schaltung wird ein Schwellwert abgelegt. Um diesen Schwellwett über dem Istwert zu halten, wird mit einer langsamen Zeitkonstante gearbeitet, so dass - wenn überhaupt - keine ausreichende Dynamik vorhanden ist, um abrupte, zeitveränderliche Bewegungen zu erkennen.

Aus PATENT ABSTRACTS OF JAPAN vol. 007, no. 266 (P-239), 26. November 1983 und aus JP 58 147670 ist eine optoelektronische Detektionsschaltung bekannt, bei der zur Elimination der Detektionsempfindlichkeit ein einziges Signal zerlegt und ein Teil des Signals zeitverzögert einem Vergleicher zugeführt wird. Es erfolgt eine Differenzierung des DC-Signals. Dabei geht es nicht um die Erfassung und vor allem nicht um die Auswertung eines für eine Schaltbewegung typischen Signalverlaufs.

In der DE 31 46 152 A1 ist ein opto-elektronisches Tastenfeld beschrieben, das auf Änderungen es Photonenstroms reagiert. In den nicht näher erläuterten Auswerteeinheiten wird die intensitätsänderung gemessen, die sich bei einer Betätigung der Taste im Photonenstrom ergibt und bei Überschreiten von Schwetlwerten ein Schaltvorgang ausgelöst. Um die Bedienungssicherheit zu erhöhen sprechen die Taster zeitverzögert an und sind Vertiefungen zur Bedienung vorgesehen. Eine Erfassung von zeitveränderlichen Bewegungsänderungen erfolgt nicht.

Aus der DE 35 24 492 ist es bekannt opto-elektrische Bedienelemente an ein Lichtleiterpaar anzukoppeln. Der Sende-Lichtleiter und der Empfangs-Lichtleiter enden unter einem elastischen Bedienelement, so dass bei Betätigung des Bedienelements sich die Reflexionsbedingungen ändern und als willentliche Betätigung gewertet werden. Eine Erfassung von zeitveränderlichen Bewegungsänderungen oder Unterscheidung von willentlichen und unbeabsichtigten Betätigungen durch Abfragen eines mehrere Schritte umfassenden Bewegungsmusters erfolgt nicht. Eine vergleichbare mit einem Lichtleiter arbeitenden Vorrichtung ist aus der FR 2 693 859 A1 bekannt.

In der DE 35 26 992 C2 werden vorzugsweise für ein Kochfeld opto-elektronische Schaltelemente vorgeschlagen, wobei verhindert werden soll, das unbeabsichtigt abgelegte Gegenstände wie z.B. ein Kochbuch einen Schaltvorgang auslösen. Hierzu wird, da eine zeitveränderliche Bewegungsänderung nicht erfasst werden kann, die Verweilzett eines Gegenstands auf dem Schaltelement verhältnismäßig lange bis zu 10 Sekunden überprüft und eine Schaltvorgang nur ausgelöst, wenn die Verweilzeit kleiner ist. Dies mag für Kochfelder noch angehen, da auch die Wärmezufuhr eine gewisse Zeit benötigt, für übliche Schalter ist jedoch eine kürzere Reaktionszeit erforderlich.

Aus der DE 42 12 562 A1 ist femer eine gekapselte, allerdings mechanisch arbeitenden Folientastatur bekannt. Als Betätigungselement sind Schnappscheiben vorgesehen.

Aufgabe der Erfindung ist, einen verbesserten opto-elektronischen Schalter, insbesondere einen opto-elektronischen Schalter mit hoher Funktionssicherheit zu schaffen.

Diese Aufgabe wird mit einer Vorrichtung mit den Merkmalen des Anspruchs 1 gelöst.

Grundgedanke der Erfindung ist, die Veränderung des von einem oder mehreren Sendeelementen stammenden, an einem Objekt reflektierten oder gestreuten Licht mit mindestens einem Empfangselement zu messen, und das von dem Empfangselement generierte Signal mindestens einer Auswerteeinheit zuzuführen, die nach vorgegebenen Kriterien anhand der Signaländerungen entscheidet, ob ein Schaltvorgang ausgelöst wird oder nicht. Unter "Licht" sind hierbei elektromagnetische Wellen beliebiger Wellenlänge, insbesondere jedoch sichtbares Licht und Infrarotstrahlung zu verstehen.

Die Erfindung wird nun anhand eines Ausführungsbeispiels näher erläutert. Es zeigen:
- Fig. 1: ein erstes Ausführungsbeispiel eines opto-elektronischen Schalters,
- Fig. 2a: ein zweites Ausführungsbeispiel eines opto-elektronischen Schalters,
- Fig. 2b: eine Variation zum in Fig. 2a gezeigten Ausführungsbeispiel,
- Fig. 3.1: den Verlauf des Messsignals beim Überstreichen des ersten sensoraktiven Bereichs,
- Fig. 3.2: den Verlauf des Nutzsignals, wenn beispielsweise ein Tuch auf der Glasplatte rasch hin und her bewegt wird,
- Fig. 4a: den Verlauf des Nutzsignals U(t) beim Antippen des ersten sensoraktiven Bereichs,
- Fig. 4b: den Verlauf des differenzierten Bewegungssignals U₁(t) beim Antippen des ersten sensoraktiven Bereichs,
- Fig. 4c: den Verlauf des Nutzsignals U(t) beim Wegnehmen eines Fingers vom ersten sensoraktiven Bereichs,
- Fig. 4d: den Verlauf des differenzierten Bewegungssignals U₁(t) beim Wegnehmen eines Fingers vom ersten sensoraktiven Bereichs,
- Fig. 4e: den Verlauf des Nutzsignals U(t) beim Antippen des zweiten sensoraktiven Bereichs,
- Fig. 4f: den Verlauf des differenzierten Bewegungssignals U₁(t) beim Antippen des zweiten sensoraktiven Bereichs,
- Fig. 4g: den Verlauf des Nutzsignals U(t) beim Wegnehmen eines Fingers vom zweiten sensoraktiven Bereichs,
- Fig. 4h: den Verlauf des differenzierten Bewegungssignals U₁(t) beim Wegnehmen eines Fingers vom zweiten sensoraktiven Bereichs,
- Fig. 5a: den Verlauf des Messsignals beim Überstreichen des ersten sensoraktiven Bereichs,
- Fig. 5b den Verlauf des Ausgangssignals des ersten Schwellwertschalters in der in Fig. 5a dargestellten Situation,
- Fig. 6: den Verlauf der Werte U₂₀(t), U_{R}(t), sowie U_{R}(tₒ)
- Fig. 7a: ein drittes Ausführungsbeispiel eines opto-elektronischen Schalters
- Fig. 7b: eine Variation zu dem in Fig. 7a gezeigten Ausführungsbeispiel
- Fig. 8: Signalverläufe von U"(t) (Ausführungsbeispiel 3)
- Fig. 9: Ein Ausführungsbeispiel mit einem Lichtleiter
- Fig. 10,11: Anordnungen zur Erzeugung einer Asymmetrie zwischen den Sendeelementen.

Die Ausführungsbeispiele zeigen verschieden Ausgestaltungen eines opto-elektronischen Schalters, der mit wenigstens einem Licht emittierenden Sendeelement und wenigstens einem Empfangselement ausgerüstet ist. Das Empfangselement gibt seine Signale, deren Wert von der empfangenen Lichtmenge abhängt, an eine Auswerteeinheit weiter, in der zumindest ein Schaltelement seinen Schaltzustand ändert, wenn der Wert des ersten Signals oder der Wert eines aus diesem Signal abgeleiteten weiteren Signal vorgegebene Grenzwerte über- oder unterschreitet. Sende- und Empfangselement können so angeordnet sein, dass das vom Sendeelement kommende Licht von Objekten, die sich innerhalb eines bestimmten Bereichs befinden, öder von einem in einem vorgegebenen räumlichen Verhältnis zu Empfangselement und Sendeelement stehenden beweglichen Element derart gestreut oder reflektiert wird, dass zumindest ein Teil dieses gestreuten oder reflektierten Lichtes in das Empfangselement gelangt. Damit verursacht die durch eine Bewegung des Objekts oder des beweglichen Elements verursachte Änderung der vom Empfangselement empfangenen Menge an reflektiertem oder gestreuten Licht eine Zustandsänderung des Schaltelements, wenn die Bewegung innerhalb von Grenzen eines vorgegebenen Bewegungsmusters liegt.

Dieses Bewegungsmuster ist vorzugsweise ein Antippen eines definierten Bereiches mit Finger, Hand oder einem anderen Körperteil. Angetippt werden kann z.B. ein definierter Bereich einer Glas- oder Plexiglasscheibe oder eines mit Sendeund/oder Empfangselement verbundenen Lichtleiters.

Das angesprochene bewegliche Element kann z.B. eine Schnappfeder sein, wie sie in üblichen Schaltern zum Teil verwendet wird. Erkannt wird von der Auswerteeinheit dann das Bewegungsmuster dieser Schnappfeder allein oder in Ergänzung zu der Annäherung des Objekts. Z.B. kann die Schnappfeder auf dem Näherungssensor liegen, um dem Benutzer den Schalteffekt taktil zu verdeutlichen, allerdings kann auch die Bewegung des beweglichen Elements allein erfasst und ausgewertet werden. Die Schnappfeder ist gegen eine Rückstellkraft bewegbar und kann z.B. beim Bewegen gegen die Rückstellkraft einen Totpunkt überwinden.

Die Äuswerteeinheit ermittelt zeitveränderliche Bewegungsänderungen, wie insbesondere die Geschwindigkeitsänderung des Objekts beim abrupten Abbremsen an der Bedienoberfläche des Schalters oder des beweglichen Elements beim Ende der Betätigung durch den Benutzer, und erkennt diese Bewegungsänderung des Objekts oder des vom Objekt betätigten beweglichen Elements als Antippen. Vorzugsweise ist das Bewegungsmuster das Antippen einer Bedienoberfläche des opto-elektronischen Schalters oder des beweglichen Elements durch das Objekt, ein Verweilen des Objekts für eine vorbestimmte Verweildauer sowie ein Abheben des Objekts um mehr als eine vorbestimmte Entfernung von der Bedienoberfläche.

In den Ausführungsbeispielen ist meist von einem Sendeelement und einem . Empfangselement die Rede, wobei selbstverständlich auch mehrer für sich oder parallel arbeitenden Elemente vorgesehen sein können. Sendeelement und Empfangselement - egal wie viele gemeinsam arbeiten - bilden wenigstens eine Sensoreinheit, die mit Hilfe der Auswerteeinheit das gesamte Bewegungsmuster vorzugsweise alleine erkennt. Zusätzliche Sensoreinheiten als Blockiermittel, die als Zusatzhilfsmittel willentliche von unbeabsichtigten Bewegungsänderungen wie z.B. dem Aufstellen eines Topfs oder einer Überwischbewegung unterscheidbar machen sollen, sind nicht erforderlich.

### Erstes Ausführungsbeispiel

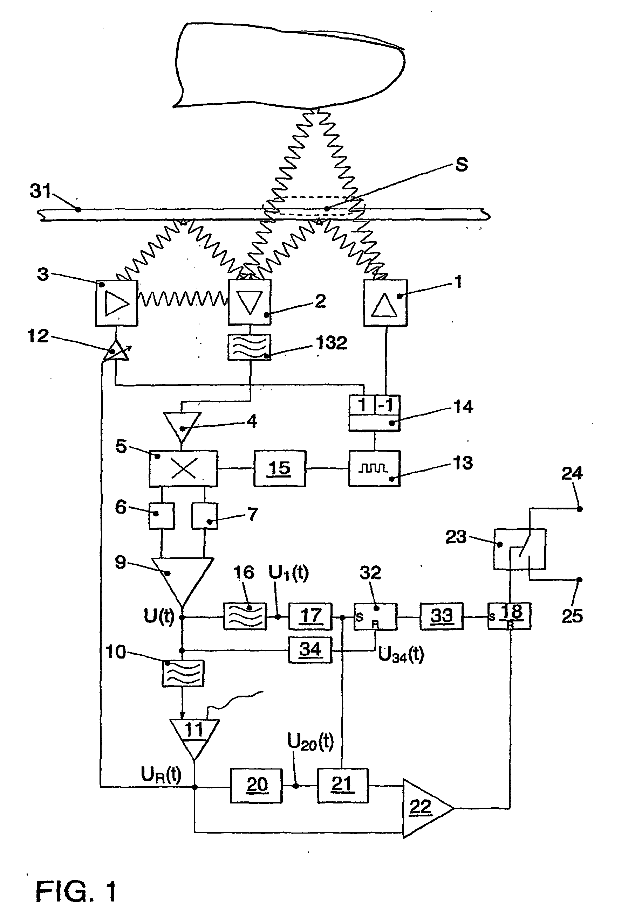

In Figur 1 ist ein erstes Ausführungsbeispiel eines opto-elektronischen Schalters dargestellt:

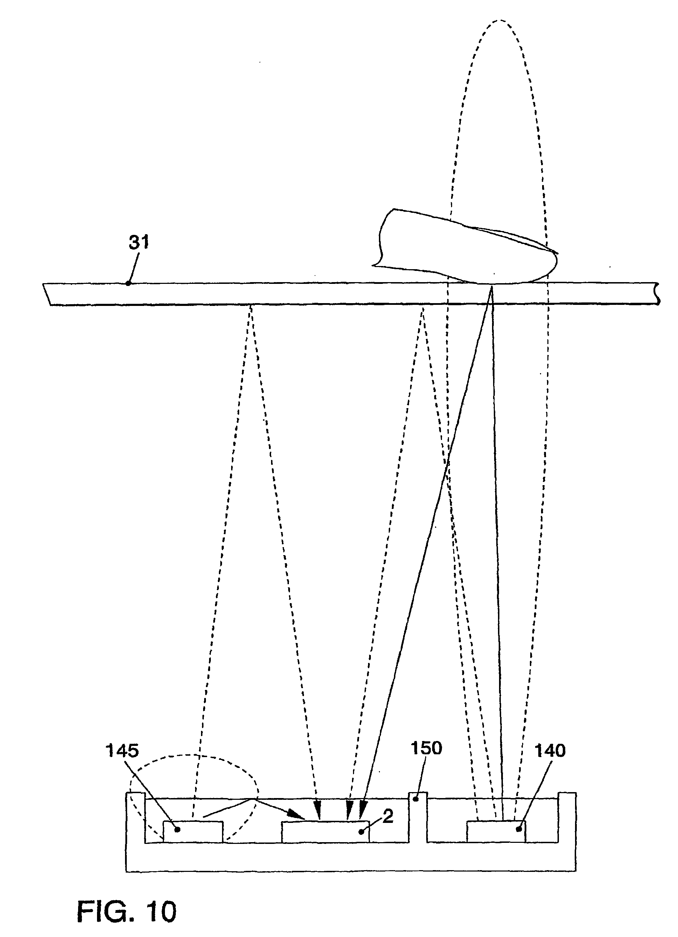

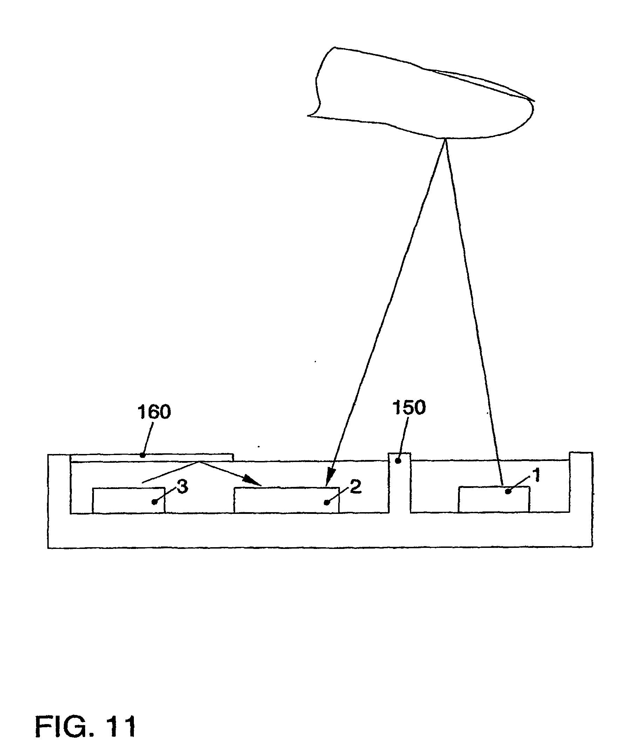

Unter einer Glasplatte 31 sind wenigstens zwei Leuchtdioden 1,3 als Sendeelemente angeordnet, deren Licht zumindest teilweise an der Glasplatte 31 als Transmissionselement reflektiert werden kann, diese auch durchdringt und nach Reflexion bzw. Streuung teilweise auf die Photodiode 2 auftrifft. Im vorliegenden Beispiel wird das Licht der ersten Leuchtdiode 1 an einem Finger reflektiert. Als Photodiode kann auch eine entsprechend beschaltete Leuchtdiode dienen. Die Glasplatte oder eine andere Oberfläche sollte für Licht zumindest in einem bestimmten Wellenlängenbereich durchlässig sein. Das von der Leuchtdiode 3 emittierte Licht dient nicht als Messstrecke, sondem wird nur zur Fremdlichtkompensation benötigt. Es ist deshalb denkbar und in manchen Fällen zweckmäßig, den Lichtweg dieser Leuchtdiode dahingehend zu blockieren, dass er nicht in den Außenraum treten kann. Eine Anordnung zum Blockieren einer der beiden Lichtstrahlen ist in Fig. 11 dargestellt. Weiterhin ist denkbar, die erste Leuchtdiode als Leuchtdiode mit gebündelter Lichtabgabe nach vorn wie z.B. als weitabstrahlende Laserdiode und die zweite Leuchtdiode als nur im Nahfeld abstrahlende Leuchtdiode auszubilden (Fig. 10).

Das Licht der Leuchtdiode 1 wird an der Glasplatte 31 nur teilweise reflektiert und tritt im übrigen somit in den Außenraum aus, wobei es wiederum von einem Objekt, hier einem Finger, reflektiert wird und somit teilweise in die Photodiode 2 zurückgestreut werden kann. Anstelle des Objekts könnte jedoch ein bewegliches Element, wie z.B. eine Schnappscheibe gemäß dem dritten Ausführungsbeispiel verwendet werden, sofern eine Fremdlichtkompensation erforderlich ist, weil das bewegliche Element z.B. in einem gewissen Wellenbereich transparent ist. Die beiden Leuchtdioden werden mittels eines Taktgenerators 13 mit Spannung versorgt, wobei das Signal einer der beiden Leuchtdioden invertiert wird. Bei gleichmäßiger Leuchtleistung der Leuchtdioden und bei genauer symmetrischer Reflektion, beziehungsweise bei geeigneter Regelung der Leuchtstärke mindestens einer der beiden Leuchtdioden (s. unten) steht am Ausgang der Photodiode 2 ein Gleichspannungssignal an, welches um Gleichspannungs- und niederfrequente Wechselanteile zu beseitigen einem Hochpass 132 zugeführt wird. Der Hochpass 132, dessen Grenzfrequenz unterhalb der Frequenz des Taktgenerators 13 liegt, läßt nur Wechselanteile durch, so dass bei entsprechender Ausgangsleistung der Leuchtdioden 1,3 das ihm zugeführte Signal zu "0" wird. Mit dieser Anordnung werden Einflüsse von Fremdlichtquellen ausgeschlossen.

Dieses so gefilterte Signal wird einem Verstärker 4 und dann einem Synchrondemo-dulator 5 zugeführt. Der Synchrondemodulator 5 erhält sein Taktsignal vom Frequenzgenerator 13, wobei dieses Taktsignal durch das Laufzeitglied 15 zur Anpassung an die Signallaufzeiten im Hochpass 132 und im Verstärker 4 entsprechend verzögert ist. Der Synchrondemodulator 5 teilt das im Signalweg des Lichtempfängers 2, des Hochpassfilters 132 und des Verstärkers 4 gemeinsame Signal der Lichtquellen 1 und 3 wieder auf zwei getrennte Wege auf. Die vom Synchrondemodulator 5 herausgeschnittenen Signalabschnitte werden in den Tiefpassfiltern 6 und 7 von störenden Spektralbereichen bereinigt und dem Vergleicher 9 zugeführt. Im dargestellten Fall besteht der Vergleicher 9 aus einem einfachen Operationsverstärker. An den Ausgängen der jeweiligen Tiefpassfilter 6 und 7 stehen die den Lichtsendern entsprechenden Differenzwerte an. Im entsprechend abgestimmten Zustand also zwei mal der Wert Null. Diese beiden Signale werden dem Vergleicher 9 zugeführt. Am Ausgang dieses Vergleichers liegt der Spannungswert U(t), das Nutzsignal an. Dieses Signal wird noch über einen Tiefpass 10 der Signalzentrierstufe 11 zugeführt.

Der Ausgang der Signalzentrierstufe 11 ist mit einem Regler 12 verbunden, der zumindest die Signalspannung für die Leuchtdiode 3 regelt. Durch diese Anordnung wird erreicht, dass sich das Nutzsignal zwar bei einer Änderung der Reflektion des von der Leuchtdiode 1 ausgesandten Lichtstrahls ändert, jedoch stets wieder auf den Nullwert zurückgeführt wird. Die Zeitkonstante für dieses Zurückführen wird im Ausführungsbeispiel durch den Tiefpassfilter 10 bestimmt.

Die bisher beschriebene Anordnung ist auch aus der WO 95/01561 bekannt, deren Offenbarungsgehalt hiermit auch zum Gegenstand der vorliegenden Anmeldung gemacht wird. Sie wurde dort insbesondere zur Detektion von Wassertropfen auf der Glasscheibe vorgeschlagen. Im vorliegenden Fall wird das Nutzsignal U(t) dahingehend genutzt, dass wenigstens ein sich auf der Glasplatte befindender sensoraktiver Bereich S1 als Schaltfläche genutzt werden kann, das heißt, dass ein Antippen dieses Bereiches einen Schaltvorgang auslöst. Diese Aufgabe kann mit nachfolgend beschriebener Schaltung gelöst werden:

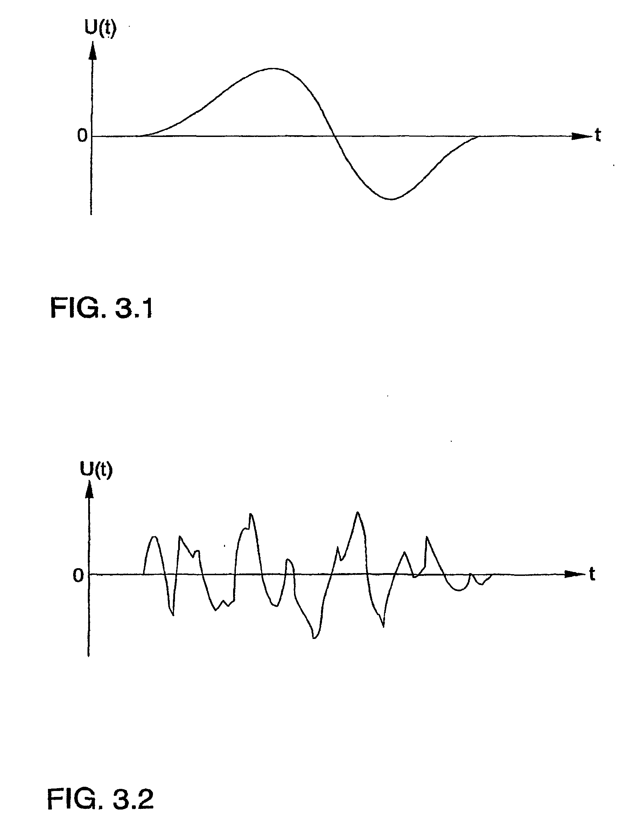

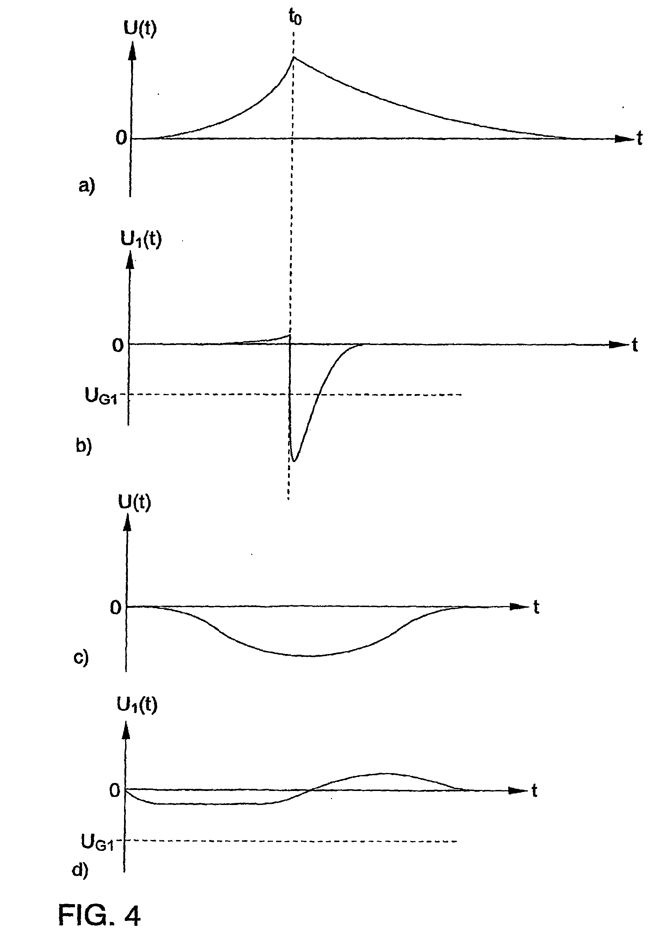

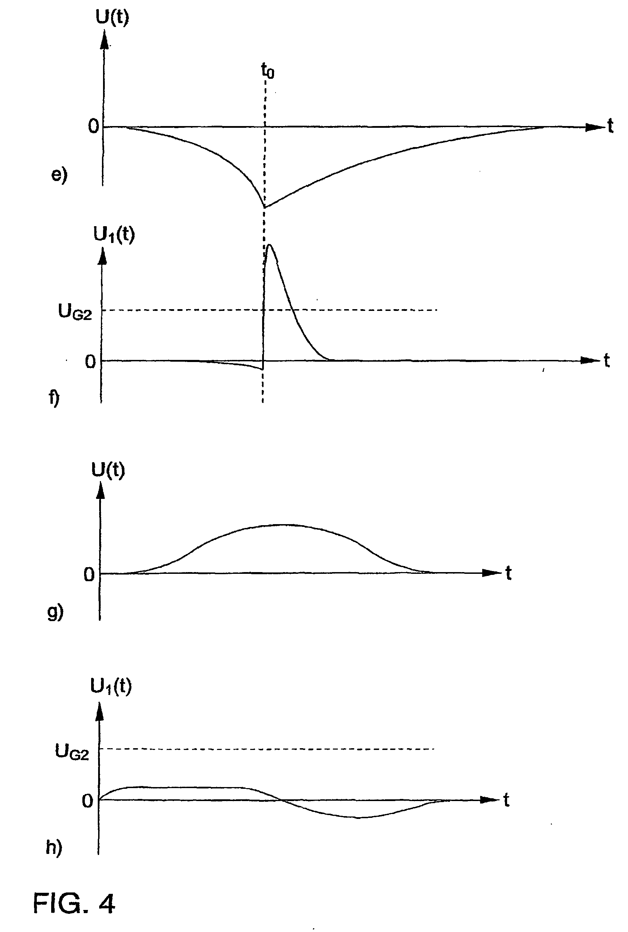

In den Fign. 3.1, 3.2, 4 ist das von der oben beschriebenen Sensoreinrichtung abgegebene Nutzsignal U(t) bei verschiedenen Situationen dargestellt. In Fig. 4a ist das Nutzsignal U(t) beim Antippen des sensoraktiven Bereichs S1 aufgetragen. Durch ein solches Signal soll ein Schaltvorgang ausgelöst werden. In den Fign. 3.1 bzw. 3.2 sind Nutzsignalverläufe aufgetragen, wie sie beim einmaligen Überstreichen bzw. beim Hin- und Herwischen über den ersten sensoraktiven Bereich S auftreten. Solche Signalverläufe sollen keinen Schaltvorgang auslösen. Dieses Ziel wird bei diesem Ausführungsbeispiel wie folgt erreicht (Fig. 1):

Das Nutzsignal U(t) wird dem Hochpassfilter 16 zugeführt, der hier als Differenzierglied wirkt, so dass an dessen Ausgang der Wert U₁(t) des differenzierten Bewegungssignals ansteht. Bei einer Bewegung eines Objekts, beispielsweise eines Fingers, auf die sensoraktive Oberfläche der Glasplatte 31 hin, steigt der Wert U(t) des Nutzsignals analog zur Bewegung langsam an und bleibt abrupt stehen, wenn der Finger auf der Glasplatte 31 abgebremst wird, siehe Figur 4a. Bleibt der Finger unbewegt liegen, wird der Wert U(t) des Nutzsignals längsam wieder auf U₀ zurück geregelt. Die abrupte Wertänderung des Nutzsignals führt am Ausgang des Hochpassfilters 16 zu einem Sprung des Bewegungssignalwerts U₁(t), siehe Fig. 4b. Dieses wird vom Schwellwertschalter 17 bei Überschreitung eines vorgegebenen im Beispiel negativen Wertes U_{G1} erkannt und der mit dem Set-Eingang des ersten FlipFlop 32 verbundene Ausgang des ersten Schwellwertschalters 17 wird auf aktiv gesetzt und somit das erste FlipFlop 32 gesetzt. Die Grenzfrequenz des Hochpassfilters 16 wird so gewählt, dass ein Antippen mit mäßiger Geschwindigkeit noch zu einem gut zu detektierenden Signal führt. Die Grenzfrequenz könnte beispielsweise im Bereich von 10 Hertz liegen.

In diesem Fall wird also ein aus dem Nutzsignal erzeugtes Signal, nämlich das durch Differentiation gewonnene Bewegungssignal verwendet, das einen ersten Vorgang auslöst, wenn dessen Wert U₁(t) einen bestimmten Grenzwert U_{G1} überschreitet. Es sind jedoch auch Schaltungsanordnungen und Anwendungsfälle denkbar, bei denen das Nutzsignal direkt herangezogen wird und einen Vorgang - Zustandsänderung des FlipFlops - auslöst, wenn der Wert U(t) des Nutzsignals einen bestimmten Wert über- oder unterschreitet.

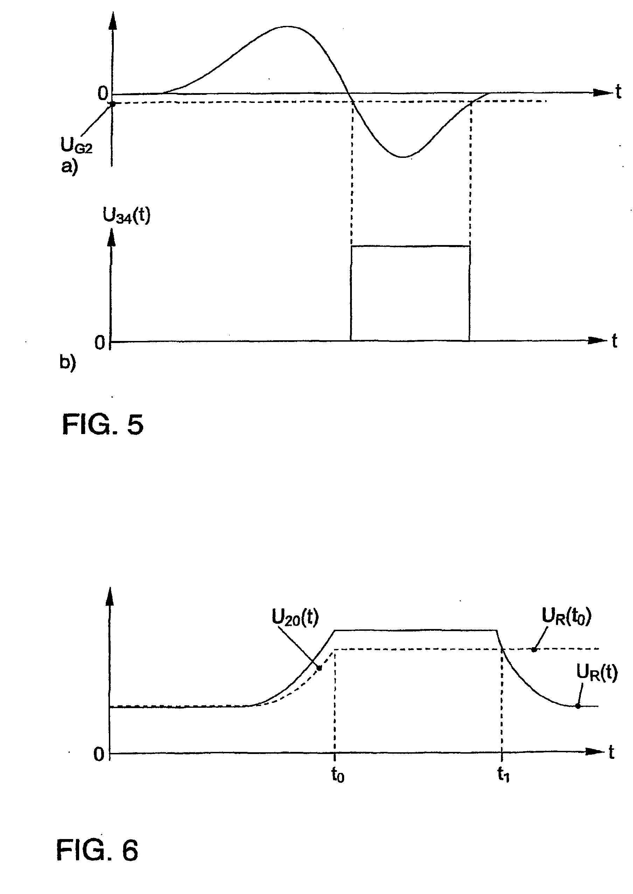

Jede Bewegung, die schnell genug ist und den ersten sensoraktiven Bereich überstreicht, löst diesen Vorgang aus, d.h., der Ausgang des ersten FlipFlops 32 wird zunächst auf aktiv gesetzt. Dazu reicht auch ein Überwischen oder ähnliche Bewegungen aus, die jedoch nicht als willentlicher Schaltvorgang erkannt werden sollen (s. Fign. 3.1 und 3.2). Deshalb wird das Nutzsignal einem zweiten Schwellwertschalter 34 zugeführt, welcher aktiv wird, wenn der Wert U(t) des Nutzsignals einen bestimmten zweiten Schwellwerts U_{G2} unterschreitet. Hier wird ausgenutzt, dass die Entfernung eines Objekts (Wegnahme eines Fingers) zu einem Absinken von U(t) in entgegengesetzter Richtung im Verhältnis zur Annäherung führt, im Beispiel in den negativen Bereich (Fig. 3.1). Bei Überschreitung des zweiten Schwellwertes U_{G2} des zweiten Schwellwertschalters 34 wird dessen Ausgang U₃₄(t) auf aktiv gesetzt (s. Figur 5).

Der Ausgang des Schwellwertschalters 34 ist mit dem Reset-Eingang des FlipFlops 32 verbunden, so dass bei einem Überwischen oder ähnlichem, welches das FlipFlop 32 auf aktiv gesetzt hat, dieses kurze Zeit später wieder auf Null zurückgesetzt wird. Das Ausgangssignal des FlipFlops 32 wird der Zeitdetektionsschaltung 33 zugeführt. Diese Schaltung ist so eingestellt, dass ihr Ausgang nur dann auf aktiv gesetzt wird, wenn das FlipFlop 32 länger als eine vorbestimmte Zeit Δt₁, beispielsweise 100 ms, aktiv war. Diese vorbestimmte erste Zeitspanne Δt₁ entspricht etwa der übliche Mindestverweilzeit eines Fingers, einer Hand oder eines anderen Körperteil beim Antippen eines als elektrisches Schaltelement ausgebildeten Schalters.

Der Ausgang der Zeitdetektionsschaltung 33 ist mit dem Set-Eingang des zweiten FlipFlops 18 verbunden. Bei einem willentlichen Antippen der sensoraktiven Fläche wird somit der Ausgang des zweiten FlipFlops 18 auf aktiv gesetzt, da hier die Zeit zwischen Setzen des ersten FlipFlops 32 und Rücksetzen dieses FlipFlops größer ist als Δt₁, mit anderen Worten: Der Finger bleibt länger als Δt₁ auf der sensoraktiven Fläche 26. Bei Bewegungen jedoch, die keinen Schaltvorgang auslösen sollen - beispielsweise Überwischen mit einem Tuch -, ist die Zeit zwischen Setzen und Zurücksetzen des ersten FlipFlops 32 kleiner als Δt₁, so dass diese Bewegungen deshalb nicht zum Setzen des zweiten FlipFlops 18 führen. Durch Antippen der sensoraktiven Fläche wird also der Zustand des zweiten FlipFlops 18 kontrolliert verändert. Der Ausgang des FlipFlop 18 kann noch mit einem Schalter 23, beispielsweise ein Relais, verbunden sein.

Von der Auswerteeinheit wird also folgendes Bewegungsmuster erkannt: Annähern eines Objekts - apruptes Abbremsen des Objekts - Verharren des Objekts für eine Zeitspanne, die eine vorgegebene Zeitspanne übersteigt. Wird dieses Bewegungsmuster erkannt, wird der Schaltzustand eines Schaltelements, hier des zweiten FlipFlops 18, geändert.

Ein Wegnehmen des Fingers wird vom Schwellwertschalter 17 nicht erkannt, da die Änderung des Wertes U(t) des Nutzsignals in anderer Richtung erfolgt und nach der Differentiation zu gering ist (Fig. 4c) und somit der Wert U₁(t) des durch Differentiation gewonnenen Bewegungssignals den ersten Grenzwert U_{G1} nicht überschreitet.

In vielen Anwendungsfällen wird es erwünscht sein, dass das durch das Antippen der sensoraktiven Fläche 26 gesetzte zweite FlipFlop 18 durch gezielte Wegnahme des Fingers wieder zurückgesetzt wird. Dies ergibt dann die Funktion eines Tasters. Es ist jedoch vorteilhaft, wenn das Löschen des FlipFlops 18 erst dann erreicht wird, wenn der Finger einige Millimeter von der Glasplatte entfernt ist, um ein versehentliches Löschen des FlipFlops durch eine minimale Bewegung zu verhindern. Im hier dargestellten Ausführungsbeispiel wird dieses Problem wie folgt gelöst:

Der Momentanwert des am Ausgang der Signalzentrierstufe 11 anliegenden Steuersignales U_{R}(t) wird zu einem Zeitpunkt abgetastet und gespeichert, an dem sich das annähernde Objekt noch kurz vor der Bedienoberfläche befindet. Um dies im Ausführungsbeispiel zu erreichen, wird dieses Signal der Verzögerungsschattung 20 zugeführt. Der am Ausgang der Verzögerungsschaltung 20 anliegende Spannungswert U₂₀ wird im Speicher 21 zu dem Zeitpunkt t₀ gespeichert, zu dem am Ausgang des ersten Schwellwertschalters 17 ein Signal ansteht, also zu dem Zeitpunkt, zu dem der erste Schwellwertschalter 17 den Zeitpunkt des Antippens erkannt hat. Alternativ kann auch eine Multiplikation des am Ausgang der Signalzentrierstufe 11 anstehenden Signals mit einem Wert kleiner 1 erfolgen und dieser Wert gespeichert werden. In beiden Fällen ergibt sich damit eine Abhängigkeit von U_{R}(t), so dass der so gespeicherte Wert U_{R}(t₀) weder vom alterungsabhängigen Zustand z.B. der Glasplatte, von der Temperatur oder anderen Umständen abhängig ist. Der so gespeicherte Wert U_{R}(t₀) wird einem ersten Eingang des Komparators 22 zugeführt. Am zweiten Eingang des Komparators liegt das Steuersignal mit dem Wert U_{R}(t) an. Solange der Wert des Steuersignals über dem Ausgangswert des Speichers 21 liegt, liefert die Komparatorschaltung 22 kein Ausgangssignal. Wenn jedoch der Wert des Steuersignals zum Zeitpunkt t₁ unter den gespeicherten Wert sinkt, wird der Ausgang des Komparators auf aktiv gesetzt. Die Signale U₂₀, U_{R}(t) und Ü_{R}(t₀) sind in Fig. 6 dargestellt. Mit diesem Signal wird das zweite Flipflop 18 zurückgesetzt.

Es ist auch denkbar, nicht alle Schwellwerte, Zeitkonstanten usw. der verwendeten Bauteile unveränderlich festzulegen, sondem zumindest teilweise Bauteile zu verwenden, bei denen die entsprechenden Werte mittels eine Steuereingangs von außen verändert werden können. Somit könnte das zu erkennende Bewegungsmuster bedarfsweise, beispielsweise durch die Software eines Gesamtsystems, in dem der Schalter eingebaut ist, vorgegeben werden.

Dieses erste Ausführungsbeispiel hat insbesondere folgende Vorteile:
- Die Lage der Glasplatte - es kann hier selbstverständlich auch eine Platte aus einem anderen Material verwendet werden, es muss lediglich für den gewählten Spektralbereich durchlässig sein - relativ zu den als Sendeelemente dienenden Leuchtdioden und der als Empfangselement dienenden Photodiode kann in einem weiten Bereich frei gewählt werden.
- Ein Zerkratzen/Verschmutzen der Glasplatte ist unschädlich, da die daraus resultierenden statischen Änderungen des Reflexionsverhaltens vom System ausgeglichen werden.
- Die Anordnung ist "blind" für Fremdlicht, so dass die Anordnung unter stark wechselnden äußeren Lichtverhältnissen betrieben werden kann.

### Zweites Ausführungsbeispiel

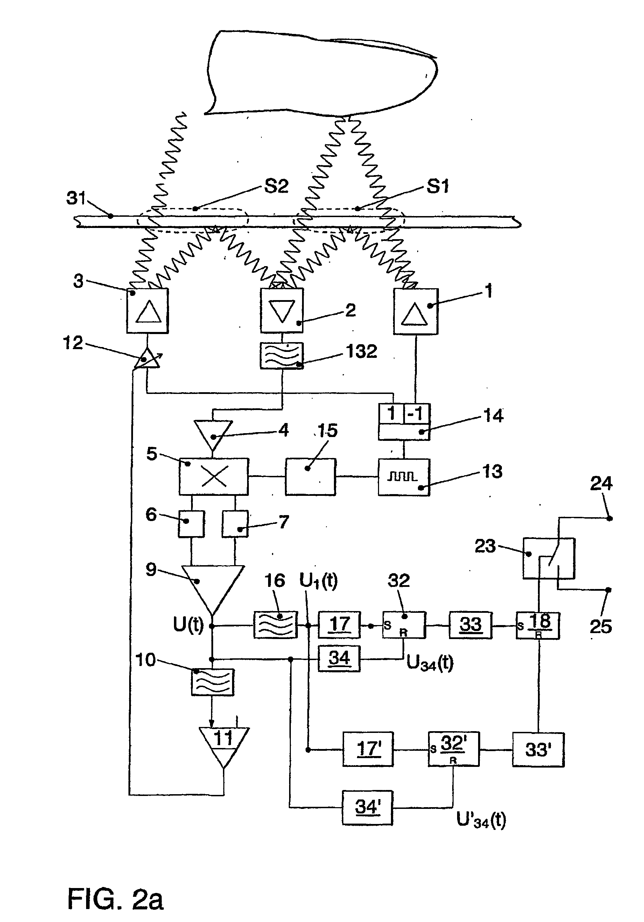

Das zweite, in Fig. 2a dargestellte, Ausführungsbeispiel ist dem ersten Ausführungsbeispiel ähnlich. Hauptunterschied ist, dass der von der zweiten Leuchtdiode 3 stammende Lichtstrahl nicht nur zur Fremdlichtkompensation, sondem auch zur Bereitstellung eines zweiten sensoraktiven Bereichs S2 auf der Glasplatte genutzt wird. Das heißt, dass die Glasplatte 31 sowohl im Strahlungsfeld der ersten, als auch im Strahlungsfeld der zweiten Leuchtdiode liegt. Der zweite sensoraktive Bereich S2 wird hier dazu benutzt, dass sein Antippen das zweite FlipFlop 18 zurücksetzt, nicht die Wegnahme des Fingers vom ersten sensoraktiven Bereichs S1. Es entsteht somit die Funktion eines Wippschalters, wobei ein Antippen des ersten sensoraktiven Bereichs S1 das zweite FlipFlop 18 setzt, und somit beispielsweise das Schaltelement 23 schließt, und ein Antippen des zweiten sensoraktiven Bereichs S2 das zweite FlipFlop 18 zurücksetzt, und damit beispielsweise das Schaltelement 23 wieder öffnet. Die Funktionsweise ist wie folgt:

Bezüglich der Erzeugung des Nutzsignals und des Setzens des zweiten FlipFlops 18 kann auf die oben gemachten Ausführungen verwiesen werden. Die Schaltungsanordnung und Funktion derselben sind der des ersten Ausführungsbeispiels identisch.

Für das Weitere wird ausgenutzt, dass beim Antippen des zweiten sensoraktiven Bereichs S2 die Signalverläufe des Nutzsignals U(t) und des Bewegungssignals U₁(t) denen beim Antippen des ersten sensoraktiven Bereichs S1 entsprechen, jedoch gegenüber diesen invertiert sind. In den Figuren 4e und 4f sind U(t) bzw. U₁(t) für ein Antippen des und in den Figuren 4g und 4h sind U(t) bzw. U₁(t) für die Wegnahme eines Fingers vom sensoraktiven Bereich S2 dargestellt.

Das Nutzsignal und das Bewegungssignal werden mittels des dritten Schwellwertschalters 17', des vierten Schwellwertschalters 34', des dritten FlipFlops 32' und der zweiten Zeitdetektionsschaltung 33' ausgewertet. Die Auswertung entspricht der Auswertung der Signale, die beim Antippen des ersten sensoraktiven Bereichs entstehen, mit dem Unterschied, dass gilt: U_{G1}'= - U_{G1}, wobei U_{G1}' der Grenzwert des dritten Schwellwertschalters 17' ist und U_{G2} = - U_{G2}, wobei U_{G2}' der Grenzwert des vierten Schwellwertschalters 34' ist. Der Ausgang der zweiten Zeitdetektionsschaltung 33' ist mit der Reset-Taste des zweiten FlipFlops 18 verbunden, so dass ein Antippen des zweiten sensoraktiven Bereichs S2 zum Zurücksetzen dieses zweiten FlipFlops 18 und somit zum Öffnen des Schaltelements 23 führt.

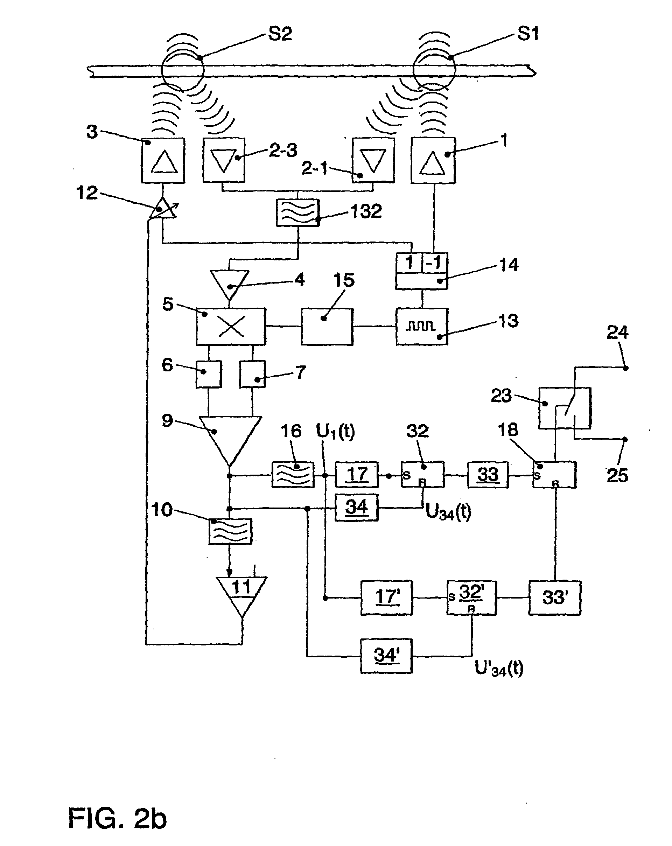

Eine Variante zum zweiten Ausführungsbeispiel ist in Fig. 2B dargestellt. Hier wird jeder Leuchtdiode 1, 3 eine eigene Photodiode 2-1 bzw. 2-3 zugeordnet. Die beiden Photodioden 2-1 und 2-3 sind parallelgeschaltet und verhalten sich für die Auswerteeinheit deshalb wie eine einzige Leuchtdiode. Diese Variante bietet folgende Vorteile:
- Die beiden sensoraktiven Bereiche S1 und S2 können sehr leicht und beliebig weit voneinander getrennt werden.
- Es können kommerziell erhältliche Leutdiode-Photodiode-Einheiten verwendet werden.

### Drittes Ausführungsbeispiel

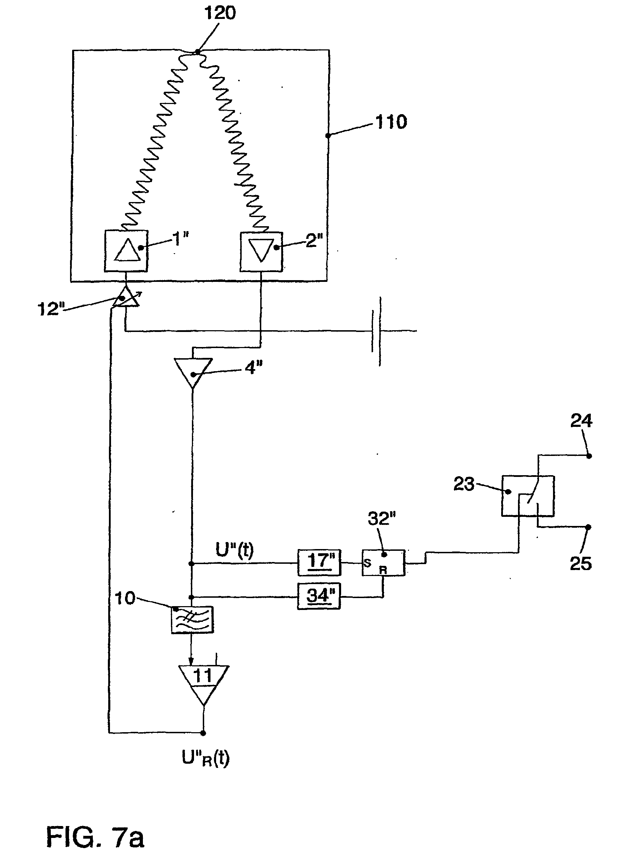

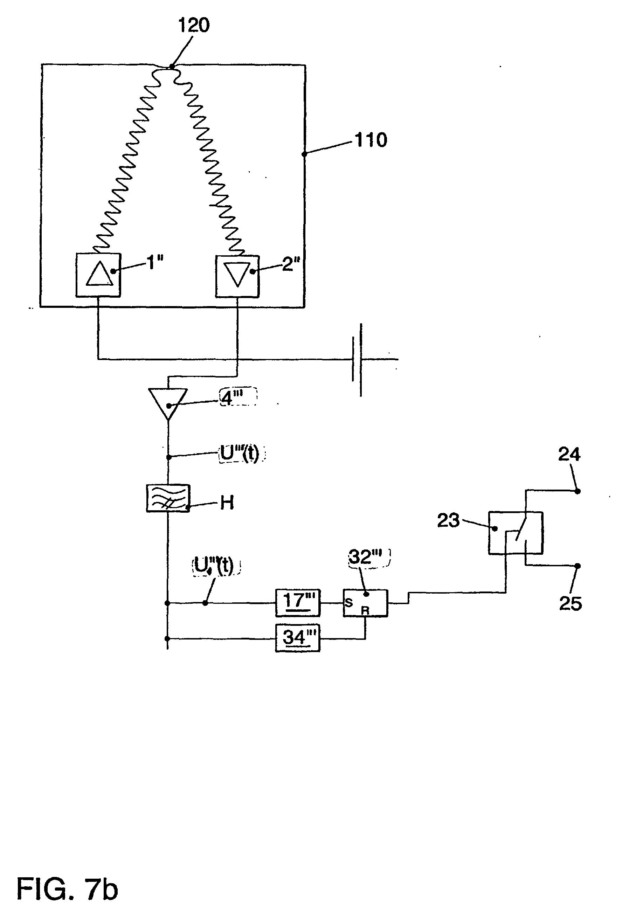

Ein drittes Ausführungsbeispiel ist in Fig. 7a dargestellt. Hier wird auf eine Fremdlichtkompensation verzichtet und als Lichtquelle dient eine einzige kontinuierlich betriebene Leuchtdiode 1". Leuchtdiode 1" und Photodiode 2" befinden sich in einem für die Wellenlänge, in der die Photodiode 2" empfindlich ist, undurchlässigen Kasten 110, an dessen Decke ein bewegliches Element, beispielsweise eine Federschnappscheibe 120 angeordnet ist. Die manuell betätigbare Federschnappscheibe 120 - in Fig. 7 in gedrücktem Zustand gezeigt - reflektiert das Licht der Leuchtdiode 1"zumindest teilweise in Richtung der Photodiode 2."Durch Betätigen der Schnappscheibe 120 werden deren Reflexionseigenschaften bezüglich des von der Leuchtdiode 1"ausgesandten Lichts verändert, so dass die Lichtmenge, die auf der Photodiode auftrifft, von der Stellung der Schnappscheibe abhängt.

Das von der Leuchtdiode abgegebene Signal wird vom Verstärker 4" Verstärkt, an dessen Ausgang das Nutzsignal mit dem Wert U"(t) ansteht. Das Nutzsignal wird über den Tiefpass 10" der Signalzentrierstufe 11" zugeführt. Die Signalzentrierstufe 11" steuert den die Spannungsversorgung der Leuchtdiode regelnden ler 12" derart, dass das Nutzsignal stets auf einen vorbestimmten Signalpegel U"₀ zurückgeregelt wird. Dadurch, dass der Signalzentrierstufe 11" der Tiefpass 10" vorgeschaltet ist, erfolgt die Rückregelung von U"(t) auf U"₀ mit einer gewissen Zeitverzögerung.

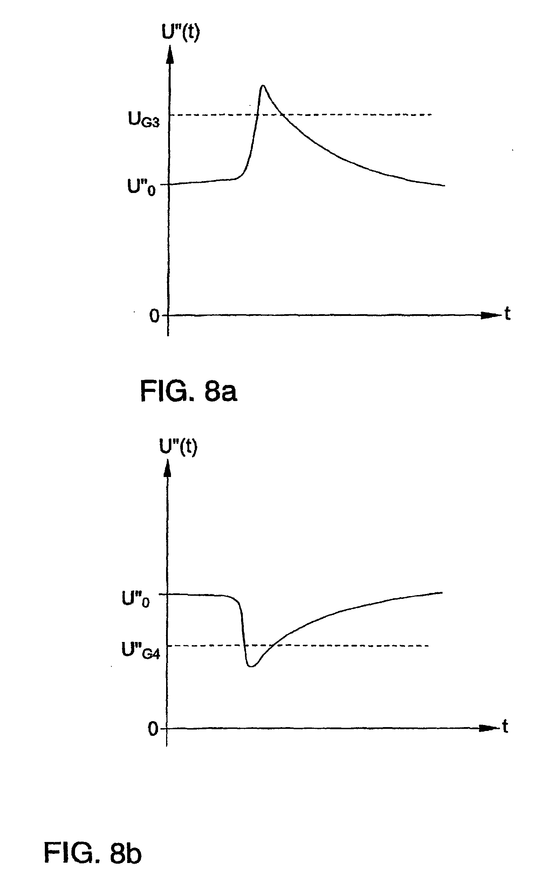

Beim Betätigen der Schnappscheibe 120 ändert sich die von der Photodiode 2" empfangene Lichtmenge und damit auch der Wert U"(t) des Nutzsignals, der anschließend wieder auf U"₀ zurückgeregelt wird. In Fig. 8a ist ein typischer Verlauf von U"(t) beim Niederdrücken, in Fig. 8b beim Loslassen der Schhappscheibe 120 gezeigt.

Da hier nicht wie in den vorherigen Ausführungsbeispieten zwischen gewollten und ungewollten Bewegungen zu unterschieden werden braucht - ein Durchdrükken der Schnappscheibe 120 ist stets als gewolltes Betätigen zu beurteilen - ist die Auswertung des Nutzsignals sehr einfach: Überschreitet U"(t) den dritten Schwellwert U_{G3}, so wird der Ausgang des dritten Schwellwertschalters 17" auf aktiv gesetzt, und somit auch das FlipFlop 32". Wird der vierte Schwellwert U_{G4} überschritten, so wird der Ausgang des vierten Schwellwertschalters 34" auf aktiv gesetzt, und somit das FlipFlop 32" zurückgesetzt

Der Einsatz einer Schnappscheibe oder einem ähnlichen Bauelement als optisch wirksames Element hat den Vorteil, dass das Erkennen einer gewollten Schalterbetätigung anhand des Nutzsignales sehr einfach ist. Als Mittel zur Unterscheidung der willentlichen von den unbeabsichtigten Bewegungsvorgängen dient dabei der Einbau in einen abgeschlossenen Kasten. Ein solches Bauelement kann natürlich auch bei einer fremdlichtkompensierten Anordnung, wie sie in Ausführungsbeispiel 1 beschrieben ist, eingesetzt werden. Auf einen lichtundurchlässigen Kasten kann dann verzichtet werden.

Eine Variante zu diesem dritten Ausführungsbeispiel zeigt Fig. 7b. Eine Regelung der Leuchtdiode 1" findet hier nicht statt. Das von der Photodiode abgegebene Spannungssignal wird mit dem Verstärker 4"' verstärkt, an dessen Ausgang das Nutzsignal U'"(t) anliegt. Dieses Nutzsignal U"'(t) unterliegt gegebenenfalls zeitlich langsamen Schwankungen durch Temperaturänderungen, Alterung und dergleichen. Dieses Nutzsignal U"'(t) wird dem Hochpass H zugeführt. Die zeitlich langsamen Änderungen des Nutzsignals U"'(t) werden von diesem Hochpass H herausgefiltert, so dass das am Ausgang des Hochpassfilters H anliegende Bewegungssignal U₁"'(t) immer Null ist, solange die Schnappscheibe 120 in Ruhe ist. Ändert sich das Nutzsignal U"'(t) aufgrund einer Bewegung der Schnappscheibe 120 jedoch schnell treten im Verlauf des Bewegungssignal U₁'"(t) kurze Pulse als zeitveränderliche Bewegungsänderung auf, beispielsweise ein positiver Puls beim Durchdrücken der Schnappscheibe, ein negativer Puls bei deren Loslassen. Diese Pulse werden durch die Schwellwertschalter 17"' und 34"' erkannt und das Flipflop 32"' entsprechend gesetzt bzw. zurückgesetzt (s. oben).

### Viertes Ausführungsbeispiel

In den bisherigen Beispielen ist das optisch wirksame Element in relativer Nähe zu der oder den Leuchtdioden und der Photodiode angeordnet. Es wird nun noch eine Anordnung vorgeschlagen, mit der eine höhere Flexibilität erreicht werden kann.

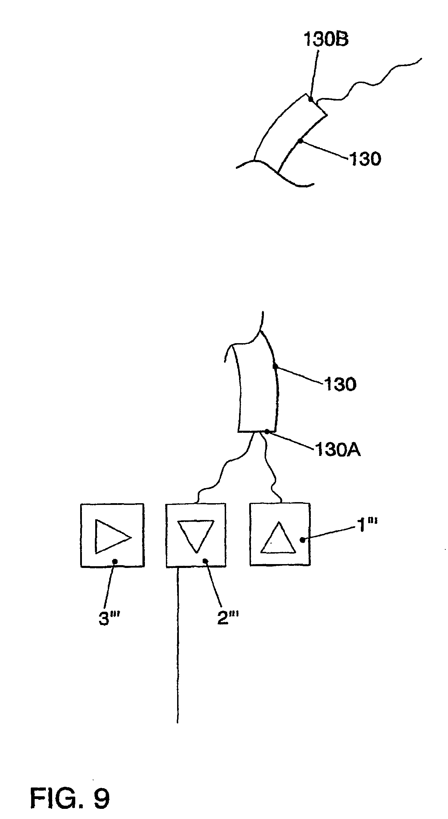

Hierfür wird ein Lichtleiter 130, beispielsweise eine Glasfaser so angeordnet, dass ein von der Leuchtdiode 1"' kommendes Licht zumindest teilweise in den Lichtleiter eindringt und sich in diesem ausbreitet und weitergeleitet wird (Fig. 9). Ein Teil desan der zweiten Grenzfläche 130B reflektierten Lichtes fällt auf die Photodiode 2"'.

Solange die zweite Grenzfläche 130B des Lichtleiters 130 frei ist, tritt fast das gesamte in den Lichtleiter gelangte Licht dort wieder aus. Dies ändert sich drastisch, wenn auf diese zweite Grenzfläche ein Gegenstand aufgebracht wird, insbesondere wenn dieser eine höhere optische Dichte als der Lichtleiter aufweist. In diesem Fall wird ein beträchtlicher Teil des Lichts an der Grenzfläche reflektiert oder in den Lichtleiter zurückgestreut und tritt aus der ersten Grenzfläche 130A wieder aus und erhöht somit die auf die Photodiode auftreffende Lichtmenge. Selbst das geringe in den "Empfangs"-Lichtleiter rückgestreute Licht ist zur Signalerkennung ausreichend. In Versuchen haben sich Werte von 2 - 3% des emittierten Lichts als rückgestreutes Licht ergeben, was allerdings von der Dicke des Lichtleiters abhängig ist. Die dabei auftretende Signaländerung kann dann entsprechend der oben dargestellten Anordnungen ausgewertet werden, so dass beispielsweise ein Antippen der zweiten Fläche 130B des Lichtleiters erkannt werden kann. Eine Fremdlichtkompensation kann natürlich ebenso wie im Ausführungsbeispiel 1 durchgeführt werden.

### Ausgestaltungen der Leuchtdiodenanordnungen

In den Figuren 10 und 11 sind Leuchtdioden/Photodiode-Anordnungen gezeigt, bei denen nur ein sensoraktiver Bereich erzeugt werden soll. In Figur 10 wird dazu eine Leuchtdiode 140 mit gebündelter Lichtabgabe nach vom wie z.B. eine Laserdiode und eine "gewöhnliche" Leuchtdiode 145 mit eher kugelförmiger Strahlungscharakteristik eingesetzt. Die Glasplatte 12 ist so weit entfernt, dass ein über der Glasplatte befindliches Objekt, beispielsweise ein Finger, nur mit dem Strahlungsfeld der Leuchtdiode 140 mit gebündelter Lichtabgabe wechselwirken kann, da das Strahlungsfeld der "gewöhnlichen" Leuchtdiode nicht weitreichend genug ist. Diese Leuchtdiode dient also nur der Fremdlichtkompensation. Zwischen Leuchtdiode 140 mit gebündelter Lichtabgabe und Photodiode kann eine Barriere 150 angebracht sein.

Bei der in Fig. 11 gezeigten Anordnung wird eine Wechselwirkung des Objekts mit dem Strahlungsfeld der Leuchtdiode 3 durch Abschattung mittels eines Reflektors 160 erreicht.

Insbesondere die in Fig. 11 dargestellte Anordnung eignet sich gut dafür, ohne Transmissionselement, also ohne eine Glas/Pexiglasscheibe, Glasfaserkabel oder ähnliches betrieben zu werden. Der sensoraktive Bereich liegt hier über der Photodiode 1. Eine entsprechende Auswerteeinheit könnte beispielsweise derart aufgebaut sein, dass ein schnelles Annähem eines Fingers als gewolltes Schalten interpretiert wird. Es können aber auch andere Anordnungen ohne Transmissionselement betrieben werden.

Ein Anwendungsbeispiel für einen erfindungsgemäßen opto-elektronischen Schalter ohne die Verwendung eines Transmissionselementes könnte beispielsweise die Erkennung des Abnehmens und Auflegens eines Telefonhörer von einer entsprechenden Schale eines Telefonapparates sein.

## Patentansprüche

1. Opto-elektronischer Schalter mit:
- wenigstens einem Licht emittierenden Sendeelement,
- wenigstens einem Empfangselement, das ein erstes Signal abgibt, dessen Wert von der empfangenen Lichtmenge abhängt,
- einer Auswerteeinheit, in der zumindest ein Schaltelement seinen Schaltzustand ändert, wenn der Wert des ersten Signals oder der Wert eines aus diesem Signal abgeleiteten weiteren Signal einen ersten Grenzwert über- oder unterschreitet,
- wobei das eine Sendeelement und das eine Empfangselement derart angeordnet sind, dass das vom Sendeelement kommende Licht von Objekten, die sich innerhalb eines bestimmten Bereichs befinden, oder von einem in einem vorgegebenen räumlichen Verhältnis zu Empfangselement und Sendeelement stehenden beweglichen Element derart gestreut oder reflektiert wird, dass zumindest ein Teil dieses gestreuten oder reflektierten Lichtes in das Empfangselement gelangt
- und wobei die durch eine Bewegung des Objekts oder des beweglichen Elements verursachte Änderung der vom Empfangselement empfangenen Menge an reflektiertem oder gestreuten Licht eine Zustandsänderung des Schaltelements verursacht, wenn die Bewegung innerhalb von Grenzen eines vorgegebenen Bewegungsmusters liegt, das einem Antippen eines definierten Bereiches entspricht,
**dadurch gekennzeichnet, dass** die Auswerteeinheit eine Geschwindigkeitsänderung beim abrupten Abbremsen des Objekts oder des vom Objekt betätigten beweglichen Elements als zeitveränderliche Bewegungsänderung ermittelt und eine solche Bewegungsänderung des Objekts oder des beweglichen Elements als Antippen erkennt.

2. Vorrichtung nach Anspruch 1, **dadurch gekennzeichnet**, das Bewegungsmuster das Antippen einer Bedienoberfläche des opto-elektronischen Schalters oder des beweglichen Elements durch das Objekt, ein Verweilen des Objekts für eine vorbestimmte Verweildauer sowie ein Abheben des Objekts um mehr als eine vorbestimmte Entfernung umfasst.

3. Vorrichtung nach einem der Ansprüche 1 oder 2, **dadurch gekennzeichnet, dass** das eine Sendeelement und das eine Empfangselement wenigstens eine Sensoreinheit bilden und dass die von der einen Sensoreinheit gelieferten Signale das gesamte Bewegungsmuster erkennt.

4. Vorrichtung nach Anspruch 3, **dadurch gekennzeichnet, dass** die Sensoreinheit als alleiniges Mittel zum Erkennen des Bewegungsmusters ausgebildet ist.

5. Vorrichtung nach Anspruch 3 oder 4, **dadurch gekennzeichnet, dass** die Sensoreinheit alleine die Signale für die Auswerteeinheit zur Bestimmung liefert, ob eine Bewegung innerhalb der Grenzen eines vorgegebenen Bewegungsmusters liegt oder nicht,

6. Vorrichtung nach einem der Ansprüche 1 bis 5, **dadurch gekennzeichnet, dass** im Strahlungsfeld mindestens eines Sendeelementes ein Transmissionselement angeordnet ist, das zumindest für einen Teil des vom Sendeelement emittierten Lichts transparent ist und das vorzugsweise eine Glasscheibe oder eine Plexiglasscheibe ist.

7. Vorrichtung nach Anspruch 6, **dadurch gekennzeichnet, dass** das Bewegungsmuster ein Antippen eines definierten Bereiches der Glas- oder Plexiglasscheibe ist.

8. Vorrichtung nach Anspruch 6, **dadurch gekennzeichnet, dass** das Transmissionselement einen Lichtleiter aufweist, dessen eine Grenzfläche im Strahlungsfeld des Sendeelements angeordnet ist.

9. Vorrichtung nach einem der vorhergehenden Ansprüche, **dadurch gekennzeichnet, dass** dem Empfangselement ein Lichtleiter, vorzugsweise eine Glasfaser, zugeordnet ist, der das reflektierte oder gestreute Licht dem Empfangselement zuleitet.

10. Vorrichtung nach Anspruch 8 oder 9, **dadurch gekennzeichnet, dass** das Bewegungsmuster ein Antippen im Bereich der zweiten Grenzfläche des Lichtleiters ist.

11. Vorrichtung nach einem der vorhergehenden Ansprüche, **dadurch gekennzeichnet, dass** wenigstens zwei Sendeelemente vorgesehen sind, welche im wechselseitigen Takt Licht gleicher Wellenlänge oder im gleichen Wellenlängenbereich emittieren und dass dem Empfänger eine Schaltung zur Fremdlichtkompensation nachgeschaltet ist.

12. Vorrichtung nach Anspruch 11, **dadurch gekennzeichnet, dass** zwei bewegliche Elemente vorgesehen sind, und dass das eine bewegliche Element im Strahlungsfeld des einen Sendeelements und das andere bewegliche Element im Strahlungsfeld des zweiten Sendeelements liegt.

13. Vorrichtung nach einem der Ansprüche 1 bis 12, **dadurch gekennzeichnet, dass** das wenigstens eine bewegliche Element, vorzugsweise ein oder zwei Schnappscheiben, gegen eine Rückstellkraft bewegbar ist.

14. Vorrichtung nach Anspruch 13, **dadurch gekennzeichnet, dass** beim Bewegen gegen die Rückstellkraft ein Totpunkt zu überwinden ist.

15. Vorrichtung nach Anspruch 14, **dadurch gekennzeichnet, dass** das Bewegungsmuster, das durch das Antippen hervorgerufen ist, das Überwinden des Totpunktes ist.

16. Vorrichtung nach Anspruch 11, **dadurch gekennzeichnet, dass** eine Bewegung des Objekts oder des beweglichen Elements nur das Licht von einem Sendeelement beeinflusst.

17. Vorrichtung nach Anspruch 6 und 11, **dadurch gekennzeichnet, dass** durch die beiden Sendeelemente zwei sensoraktive Bereiche auf dem Transmissionselement erzeuat werden.

18. Vorrichtung nach Anspruch 17, **dadurch gekennzeichnet, dass** jedem Sendeelement ein Empfangselement zugeordnet ist, und dass diese Empfangselemente elektrisch parallelgeschaltet sind.

## Claims

1. Optoelectronic switch comprising:
- at least one light-emitting transmitting element,
- at least one receiving element, which produces a first signal, the value of which is dependent upon the received light quantity,
- an evaluation unit, in which at least one switching element changes its switching state when the value of the first signal or the value of a further signal derived from said signal overshoots or undershoots a first limit value,
- wherein the one transmitting element and the one receiving element are disposed in such a way that the light coming from the transmitting element is scattered or reflected by articles, which are situated within a specific region, or by a movable element, which is in a defined spatial relationship to receiving element and transmitting element, in such a way that at least some of said scattered or reflected light passes into the receiving element
- and wherein the change of the quantity of scattered or reflected light received by the receiving element that is caused by a movement of the article or movable element causes a change of state of the switching element when the movement lies within limits of a defined pattern of motion corresponding to tapping of a defined area,
**characterized in that** the evaluation unit detects a change of speed upon the sudden braking of the article or the movable element actuated by the article as a time-variant change of motion and recognizes such a change of motion of the article or the movable element as tapping.

2. Device according to claim 1, **characterized in that** the pattern of motion comprises tapping of an operating surface of the optoelectronic switch or the movable element by the article, dwelling of the article for a predetermined dwell time as well as lifting-off of the article by more than a predetermined distance.

3. Device according to one of claims 1 or 2, **characterized in that** the one transmitting element and the one receiving element form at least one sensor unit and that the signals supplied by the one sensor unit detect the entire pattern of motion.

4. Device according to claim 3, **characterized in that** the sensor unit is designed as the sole means of detecting the pattern of motion.

5. Device according to claim 3 or 4, **characterized in that** the sensor unit alone supplies the signals for the evaluation unit for determining whether or not a movement lies within the limits of a defined pattern of motion.

6. Device according to one of claims 1 to 5, **characterized in that** disposed in the radiation field of at least one transmitting element is a transmission element, which is transparent at least for a fraction of the light emitted by the transmitting element and which is preferably a glass pane or a plexiglass pane.

7. Device according to claim 6, **characterized in that** the pattern of motion is tapping of a defined area of the glass pane or plexiglass pane.

8. Device according to claim 6, **characterized in that** the transmission element comprises an optical fibre, one boundary surface of which is disposed in the radiation field of the transmitting element.

9. Device according to one of the preceding claims, **characterized in that** associated with the receiving element is an optical fibre, preferably a glass fibre, which guides the reflected or scattered light to the receiving element.

10. Device according to claim 8 or 9, **characterized in that** the pattern of motion is tapping in the region of the second boundary surface of the optical fibre.

11. Device according to one of the preceding claims, **characterized in that** at least two transmitting elements are provided, which in a two-way alternate cycle emit light of the same wavelength or in the same wavelength range, and that a circuit for ambient light compensation is connected downstream of the receiver.

12. Device according to claim 11, **characterized in that** two movable elements are provided, and that the one movable element lies in the radiation field of the one transmitting element and the other movable element lies in the radiation field of the second transmitting element.

13. Device according to one of claims 1 to 12, **characterized in that** the at least one movable element, preferably one or two snap-action discs, is movable counter to a restoring force.

14. Device according to claim 13, **characterized in that** in the course of moving counter to the restoring force a dead centre is to be overcome.

15. Device according to claim 14, **characterized in that** the pattern of motion, which is occasioned by the tapping action, is the overcoming of the dead centre.

16. Device according to claim 11, **characterized in that** a movement of the article or of the movable element influences only the light from one transmitting element.

17. Device according to claim 6 and 11, **characterized in that** by means of the two transmitting elements two sensor-active areas are produced on the transmission element.

18. Device according to claim 17, **characterized in that** associated with each transmitting element is a receiving element, and that said receiving elements are electrically connected in parallel.

## Revendications

1. Interrupteur optoélectronique comportant :
- au moins un élément émetteur émettant de la lumière,
- au moins un élément récepteur qui délivre un premier signal dont la valeur dépend de la quantité de lumière reçue,
- une unité d'exploitation dans laquelle au moins un élément de commutation modifie son état de commutation lorsque la valeur du premier signal ou la valeur d'un autre signal dérivé de ce signal dépasse ou passe au-dessous d'une première valeur limite,
- l'un des éléments émetteurs et l'un des éléments récepteurs étant disposés de manière que la lumière provenant de l'élément émetteur soit dispersée ou réfléchie par des objets qui se trouvent à l'intérieur d'une zone déterminée ou par un élément mobile se trouvant dans un rapport spatial prédéfini par rapport à l'élément récepteur et l'élément émetteur, de manière qu'au moins une partie de cette lumière dispersée ou réfléchie parvienne dans l'élément récepteur,
- et la variation de la quantité de lumière réfléchie ou dispersée, reçue par l'élément récepteur et provoquée par un mouvement de l'objet ou de l'élément mobile, provoque un changement d'état de l'élément de commutation lorsque le mouvement se situe à l'intérieur de limites d'un modèle de mouvement prédéfini qui correspond à l'effleurement d'une zone définie,
**caractérisé en ce que** l'unité d'exploitation détermine une variation de la vitesse en cas de freinage brusque de l'objet ou de l'élément mobile actionné par l'objet en tant que changement de mouvement variable dans le temps, et reconnaît ce changement de mouvement de l'objet ou de l'élément mobile comme étant un effleurement.

2. Dispositif selon la revendication 1, **caractérisé en ce que** le modèle de mouvement comprend l'effleurement d'une surface de commande de l'interrupteur optoélectronique ou de l'élément mobile par l'objet, un séjour de l'objet pour une durée de séjour prédéterminée, ainsi qu'un éloignement de l'objet d'une distance supérieure à une distance prédéterminée.

3. Dispositif selon l'une des revendications 1 ou 2, **caractérisé en ce que** l'un des éléments émetteurs et l'un des éléments récepteurs forment au moins une unité de détection et **en ce que** les signaux fournis par une unité de détection reconnaissent l'ensemble du modèle de mouvement.

4. Dispositif selon la revendication 3, **caractérisé en ce que** l'unité de détection est réalisée en tant que moyen unique pour reconnaître le modèle de mouvement.

5. Dispositif selon la revendication 3 ou 4, **caractérisé en ce que** l'unité de détection fournit à elle seule les signaux destinés à l'unité d'exploitation pour déterminer si un mouvement se situe ou non à l'intérieur des limites d'un modèle de mouvement prédéfini.

6. Dispositif selon l'une des revendications 1 à 5, **caractérisé en ce que** dans le champ de rayonnement d'au moins un élément d'émission est disposé un élément de transmission qui est transparent au moins pour une partie de la lumière émise par l'élément émetteur et qui est de préférence une plaque de verre ou une plaque de plexiglas

7. Dispositif selon la revendication 6, **caractérisé en ce que** le modèle de mouvement est un effleurement d'une zone définie de la plaque de verre ou de plexiglas

8. Dispositif selon la revendication 6, **caractérisé en ce que** l'élément de transmission comporte un guide optique dont une surface limite est située dans le champ de rayonnement de l'élément émetteur.

9. Dispositif selon l'une des revendications précédentes, **caractérisé en ce qu'**à l'élément émetteur est associé un guide optique, de préférence une fibre de verre, qui achemine la lumière réfléchie ou dispersée vers l'élément récepteur.

10. Dispositif selon la revendication 8 ou 9, **caractérisé en ce que** le modèle de mouvement est un effleurement dans la zone de la deuxième surface limite du guide optique.

11. Dispositif selon l'une des revendications précédentes, **caractérisé en ce que** sont prévus au moins deux éléments émetteurs qui émettent, suivant un rythme réciproque, de la lumière de même longueur d'onde ou de même gamme de longueurs d'onde et **en ce qu'**un circuit de compensation de lumière parasite est monté en aval du récepteur.

12. Dispositif selon la revendication 11, **caractérisé en ce que** sont prévus deux éléments mobiles et **en ce qu'**un élément mobile se situe dans le champ de rayonnement de l'un des éléments émetteurs et l'autre élément mobile dans le champ de rayonnement du deuxième élément émetteur.

13. Dispositif selon l'une des revendications 1 à 12, **caractérisé en ce que** le ou les éléments mobiles, de préférence une ou deux rondelles-ressorts, sont déplaçables à l'encontre d'une force de rappel.

14. Dispositif selon la revendication 13, **caractérisé en ce qu'**un point mort doit être dépassé pendant le déplacement à l'encontre de la force de rappel.

15. Dispositif selon la revendication 14, **caractérisé en ce que** le modèle de mouvement, qui est provoqué par l'effleurement, est le dépassement du point mort.

16. Dispositif selon la revendication 11, **caractérisé en ce qu'**un mouvement de l'objet ou de l'élément mobile n'influence que la lumière d'un élément émetteur.

17. Dispositif selon les revendications 6 et 11, **caractérisé en ce que** deux zones actives pour la détection sont produites par les deux éléments émetteurs sur l'élément de transmission.

18. Dispositif selon la revendication 17, **caractérisé en ce qu'**à chaque élément émetteur est associé un élément récepteur et **en ce que** ces éléments récepteurs sont montés électriquement en parallèle.
